# EUROPÄISCHE PATENTSCHRIFT

(11) **EP 2 614 500 B1**
(45) Veröffentlichungstag und Bekanntmachung des Hinweises auf die Patenterteilung: **18.11.2015**
(21) Anmeldenummer: 11766900.2
(22) Anmeldetag: 07.09.2011
(51) Int. Cl.: G10H 1/32, H04H 60/05, H05K 5/03, H05K 5/02

(54) **GERÄTEDECKEL FÜR EINEN TRAGBAREN MISCHVERSTÄRKER**
COVER FOR A PORTABLE MIXER AMPLIFIER
COUVERCLE POUR UN AMPLIFICATEUR-MÉLANGEUR PORTABLE

(30) Priorität: 10.09.2010 DE 102010040533
(43) Veröffentlichungstag der Anmeldung: 17.07.2013
(73) Patentinhaber: Robert Bosch GmbH, 70442 Stuttgart (DE)
(72) Erfinder: SCHLITTMEIER, Thomas, 84032 Altdorf (DE); TAFFNER, Josef, 93093 Donaustauf (DE); SAUER, Gregor, 35510 Butzbach-Griedel (DE); BRUNHOFER, Alfred, 93479 Grafenwiesen (DE)
(86) Internationale Anmeldenummer: PCT/EP2011/065425
(87) Internationale Veröffentlichungsnummer: WO 2012/032070

(56) Entgegenhaltungen:
- DE-U1- 20 019 002
- US-A- 5 396 398

## Beschreibung

### Stand der Technik

Mischverstärker weisen im Allgemeinen Toneingänge bzw. -Eingangskanäle zur Aufnahme elektrischer Signale verschiedener Tonquellen auf, z. B. von Mikrofonen und elektrischen Instrumenten. Die verschiedenen Toneingänge können nachfolgend einzeln verstärkt, geformt und geeignet gemischt werden, wobei neben unterschiedlichen Mischverhältnisse auch Einzelwiedergaben einstellbar sind. Ein Mischverstärker weist im Allgemeinen bereits geeignete Verstärkerstufen auf, so dass Lautsprecher direkt an den Mischverstärker angeschlossen werden können. Die WO 2007/110576 A1 beschreibt eine Mischverstärkerkonsole mit geeigneten Anschlüssen und Bedieneinrichtungen.

Die elektronischen Komponenten von Mischverstärkern sind im Allgemeinen in seinem Geräteunterteil untergebracht, das eine Vielzahl Anschlussbuchsen und von Betätigungseinrichtungen aufweist, z. B. Schieberegler und drehbare Potentiometer. Diese Komponenten sind im wesentlichen auf der großflächigen Vorderseite des Geräteunterteils angebracht und gegenüber mechanischen Beschädigungen, Staubeinwirkungen sowie Flüssigkeitseinwirkungen sehr empfindlich, so dass zu ihrem Schutz im Allgemeinen ein Gerätedeckel auf dem Geräteunterteil angebracht ist. An dem Geräteunterteil ist weiterhin im Allgemeinen eine Trageeinrichtung vorgesehen, z. B. als seitliche Griffmulde in einer Seitenfläche des Geräteunterteils, damit sie nicht störend hervorsteht.

Der Gerätedeckel ist im Allgemeinen als Blechdeckel ausgelegt und wird auf die Vorderseite des Geräteunterteils aufgesetzt. Der Blechdeckel kann z. B. über zwei Öffnungen an der Frontblende des Geräteunterteils verriegeln. Somit wird der Gerätedeckel zur Benutzung abgenommen und das Geräteunterteil geeignet platziert.

Diese Öffnungen für die Verriegelung des Bleckdeckels und in der ansonsten geschlossenen Fläche der Frontblende des Geräteunterteils beeinträchtigen jedoch das Design und die Möglichkeit in der Formgebung. Weiterhin sind derartige Ausbildungen einer Frontblende mit geeigneten Öffnungen zum Teil herstellungstechnisch aufwendiger und können den inneren Konstuktionsaufbau beeinträchtigen. Auch die seitliche Griffmulde beeinträchtigt die Möglichkeiten der Formgebung und des Desings sowie den inneren Aufbau; weiterhin sind flache Ausbildungen des Geräteunterteils z.T. problematisch. Da an der Vorderseite des Geräteunterteils im Allgemeinen bereits eine Vielzahl von Bedieneinrichtungen und auch Anschlüssen vorgesehen ist, und weitere Anschlüsse, z. B. Ausgänge, an den Seitenflächen bzw. der Frontblende vorgesehen sind, ist der Platz für die Trageeinrichtung beschränkt.

Aus der DE 200 19 002 U1 ist ein anderes tragbares Behältnis für einen Mischverstärker bekannt.

### Offenbarung der Erfindung

Erfindungsgemäß wird ein Gerätedeckel (Geräte-Abdeckung) für einen tragbaren Mischverstärker geschaffen, der bereits eine Trageeinrichtung aufweist. Somit kann die Trageeinrichtung am Geräteunterteil, d. h. dem eigentlichen funktionellen Bauteil des Mischverstärkers, entfallen.

Bereits hierdurch werden einige Vorteile erreicht:
Am Geräteunterteil kann die Trageeinrichtung nunmehr vollständig entfallen, so dass das Geräteunterteil frei dimensioniert und mit seinen Anschlüssen bzw. Nutzflächen frei designed werden kann. So kann das Geräteunterteil in seiner Höhe anders, z. B. flacher ausgebildet werden. Weiterhin kann die Trageeinrichtung komfortabler, insbesondere als Griff mit freistehendem Griffbügel ausgebildet sein, so dass eine bessere Handhabung als mit z. B. einer Griffmulde ermöglicht wird.

Da der Gerätedeckel zur Benutzung abgenommen werden kann, stört die Trageeinrichtung nachfolgend nicht mehr bei der Benutzung des Geräteunterteils. Hierdurch wird insbesondere auch ein ansprechenderes Design des Geräteunterteils ermöglicht.

Erfindungsgemäß sind die Trageeinrichtung und zwei Verschlusseinrichtungen, die eine formschlüssige Verriegelung des Gerätedeckels am Geräteunterteil ermöglichen, vorzugsweise an einer Frontseite des Gerätedeckels vorgesehen. Somit sind sämtliche haptischen Elemente an dieser Frontseite bzw. Griffseite vorgesehen. Insbesondere kann die Trageeinrichtung zwischen den Verschlusseinrichtungen angeordnet sein. Somit erfolgt die Krafteinleitung durch die Tragekraft des Benutzers über die Verschlusseinrichtungen auch direkt und symmetrisch bzw. beidseitig an die sich anschließenden Verschlusseinrichtungen.

Die Integration der Verschlusseinrichtungen in den Gerätedeckel erfolgt vorteilhafterweise durch Ausbildung geeigneter Verschluss-Vertiefungen in der Deckelschale. Die Verschlusseinrichtungen können insbesondere vollständig in den Verschluss-Vertiefungen aufgenommen sein und somit nicht mehr störend vorstehen.

Die Verschlusseinrichtungen weisen vorzugsweise jeweils ein Verschlussteil auf, das z. B. vom Benutzer in Griffflächen, d.h. Flächen mit griffiger Oberfläche, z. B. mit einem Fingers betätigbar und verschiebbar ist. Die Griffflächen können z. B. aufgerauht sein, z. B. durch eine Prägung mit parallelen Stegen.

Gemäß einer besonders bevorzugten Ausbildung ist das Verschlussteil in der verriegelten Stellung an die Formgebung der Deckelschale angepasst, d. h. es steht hier nicht störend vor; hierzu kann es insbesondere mit der Deckelschale fluchten. Somit sind die Verschluss-Vertiefungen in der Deckelschale an die Höhe der verriegelten Verschlusseinrichtungen angepasst. Hierdurch wird zum einen ein angenehmes Design erreicht. Weiterhin wird der Vorteil erreicht, dass diese verriegelte Stellung für den Benutzer leicht erkennbar ist, da dann die Oberseite des Verschlussteils mit der Vorderseite der Deckelschale fluchtet bzw. nicht vorsteht. Somit ist das sichere Erkennen der verriegelten Stellung möglich. Ein weiterer Vorteil dieser fluchtenden oder integrierten Aufnahme liegt darin, dass die Verschlusseinrichtung beim Transport nicht an vorstehenden Gegenständen einhängen kann und sich somit nicht unbeabsichtigt lösen kann.

In der geöffneten bzw. entriegelten Stellung steht das Verschlussteil hingegen vor, so dass diese Entriegelung dem Benutzer sicher signalisiert wird. Hierzu kann in der Verschlusseinrichtung eine Federeinrichtung vorgesehen sein, die in die geöffnete Stellung vorgespannt ist. Bei einer Entriegelung schnappt somit das Verschlussteil jeweils vollständig in die entriegelte Stellung ein, so dass diese Position für den Benutzer sicher erkennbar ist.

Erfindungsgemäß werden hierdurch weitere Vorteile erreicht. Es ist ein einfaches Aufsetzen des Gerätedeckels möglich, wobei die Verriegelung durch Betätigung der Verschlusseinrichtung, insbesondere durch einfaches Verschieben bzw. Ziehen des Verschlussteils mittels z. B. eines einzelnen Fingers ermöglicht wird. Zum Entriegeln verschiebt der Benutzer somit das Verschlussteil, insbesondere zum Frontende hin. In der geöffneten Stellung steht das Verschlussteil am Frontende vor, so dass der Benutzer es wieder eindrücken kann, wodurch eine Verriegelung erfolgt.

Die Vorderseite kann plan oder auch leicht gewölbt sein, um ein geeignetes Design auszubilden. An ihr schließen sich z. B. ein oder zwei Seitenflächen, und eine Hinterseite an, die das Geräteunterteil umgreift.

Gemäß einer vorteilhaften Ausbildung weist der Gerätedeckel eine Deckelschale aus einem Kunststoffmaterial auf, z. B. ein belastbarer PC/ABS. Die Deckelschale kann insbesondere als Kunststoff-Spritzgussteil gefertigt sein.

Die Ausbildung aus Kunststoffmaterial ermöglicht weitere Vorteile:
Es ist ein ansprechendes Industriedesign erreichbar. Die Herstellungskosten sind insbesondere bei Ausbildung als Spritzgussteil gering. Das Gewicht kann gegenüber einem Blechteil reduziert sein. Es wird dennoch weiterhin eine sichere Abdeckung und ein sicherer Schutz vor Verstaubung und mechanischer Beschädigung erreicht. Die Belastbarkeit und der zulässige Temperaturbereich sind insbesondere bei PC/ABS verbessert; es kann z. B. eine Belastung von ca. 90 kg in einem Temperaturbereich von -20 °C bis +60 °C ohne weitere Beschädigungen erreicht werden. Die Deckelschale kann mit geeigneter Wandstärke in den jeweiligen Bereichen ausgebildet werden, so dass es gegenüber einem Blechdeckel mechanisch belastbarer ist. Die Oberfläche der Deckelschale kann ohne zusätzliche Lackierung oder Beschichtung geeignet ausgestaltet sein; evtl. Verzierungen und Beschriftungen können direkt beim Spritzgussverfahren in der Deckelschale, insbesondere deren großflächiger Vorderseite, ausgebildet werden.

Das Verschlussteil kann insbesondere aus demselben Material wie die Deckelschale gefertigt sein. Somit wird zum einen ein angenehmes Design und weiterhin wiederum ein direktes Erkennen der geschlossenen Stellung erreicht.

Vorteilhafterweise weist jede Verschlusseinrichtung zusätzlich zu dem Verschlussteil ein Rahmenteil auf, das zwischen dem Verschlussteil und der Deckelschale vorgesehen ist. Dieses Rahmenteil wirkt somit als Koppel oder Koppelglied, das an seinen Enden gelenkig an einerseits der Deckelschale und andererseits dem Verschlussteil angelenkt ist. Das Rahmenteil kann insbesondere auch zur Anbindung der Feder dienen, die gegen das Verschlussteil drückt. Somit wird die Vorspannung zwischen dem als Koppel dienenden Rahmenteil und dem Verschlussteil ausgebildet. Weiterhin kann das Rahmenteil gemäß einer bevorzugten Ausbildung auch zur Anbindung einer Eingriffseinrichtung dienen, die formschlüssig in das Geräteunterteil, z. B. dessen Frontbalken, einschnappt. Diese Eingriffseinrichtung kann insbesondere ein schwenkbarer Haken sein. Der Haken kann hierbei zum einen gelenkig am Rahmenteil angebunden sein, und weiterhin vorteilhafterweise auch ergänzend am Verschlussteil geführt sein, z. B. in einem Langloch des Verschlussteils. Durch dieses zusätzliche Führung wird eine sichere mechanische Führung an zwei Punkten erreicht. Weiterhin dient ein Langloch vorteilhafterweise zur Festlegung von Endpunkten der Schwenkbewegung des Hakens.

Der Haken kann beim Verriegeln insbesondere derartig einschnappen, dass ein akustisch hörbares Geräusch, d. h. insbesondere ein Klick-Geräusch entsteht. Somit wird der Einschnappvorgang bzw. die Verriegelung den Benutzer zum einen durch die mechanische Verrastung, die er bei Betätigung des Verschlussteils spürt, und ergänzend auch akustisch signalisiert.

Bei Ausbildung der Trageeinrichtung als Griff kann die Deckelschale sich bis in diesen Griff, insbesondere auch bis in einen Bügel des Griffs erstrecken; der Griff weist somit einen Griffbereich auf, der als Teil der Deckelschale ausgebildet ist. Hierdurch wird eine hohe mechanische Belastbarkeit und Stabilität erreicht, da der Griff somit z. B. in seiner oberen Hälfte einteilig mit der gesamten Deckelschale ausgebildet ist. Der Griff ist somit auch verliersicher ausgebildet. Der gesamte Mischverstärker bildet somit eine kompakte Einheit, wobei der Benutzer den Griff komfortabel ergreifen kann, indem er z. B. seine Hand durch das Griffloch steckt und den Bügel erfasst. Der Griffbereich der Deckelschale erstreckt sich vorteilhafterweise bis in den Bügel. Eine derartige Ausbildung der Deckelschale mit einem Loch, so dass sich die Deckelschale bis in den Bügel erstreckt, ist bei Ausbildung als Spritzgußteil mit Sprizrichtung von der Vorderseite oder mit zusätzlichem Schieber problemlos möglich.

Ergänzend ist vorteilhafterweise eine Griffschale als weiteres Bauteil von unten an den Griffbereich der Deckelschale befestigt, z. B. über Schrauben. Eine deutliche Erhöhung des Tragekomforts wird durch Einsetzen eines zusätzlichen weichen Materialteils, z. B. eines Griffgummis erreicht, das z. B. an oder zwischen die Griffschale und den Griffbereich gesetzt werden kann. Somit wird eine sichere, angenehme Haptik mit relativ wenigen Bauteilen erreicht.

### Kurze Beschreibung der Zeichnungen

- Fig. 1: zeigt eine perspektivische Aufsicht auf eine Deckelschale eines erfindungsgemäßen Gerätedeckels ohne Verschlusseinrichtungen;
- Fig. 2: zeigt eine perspektivische Ansicht eines Verschlussteils der Verschlusseinrichtung;
- Fig. 3: zeigt eine perspektivische Ansicht eines Rahmenteils der Verschlusseinrichtung;
- Fig. 4: zeigt eine perspektivische Ansicht eines Hakens der Verschlusseinrichtung;
- Fig. 5: zeigt eine perspektivische Ansicht einer Feder der Verschlusseinrichtung;
- Fig. 6: zeigt eine perspektivische Ansicht des Gerätedeckels mit einseitig geöffneter Verschlusseinrichtung;
- Fig. 7: zeigt eine Draufsicht auf den Gerätedeckel aus Figur 6 sowie Schnittdarstellungen des Deckels durch die Verschlusseinrichtung in unten geöffneter Stellung und oben geschlossener Stellung;
- Fig. 8: zeigt Vergrößerungen der Schnitte durch die Verschlusseinrichtungen aus Figur 7;
- Fig. 9: zeigt eine Unteransicht der Verschlusseinrichtung;
- Fig. 10: zeigt eine perspektivische Unteransicht der Deckelschale;
- Fig. 11: zeigt eine perspektivische Ansicht der Griffschale;
- Fig. 12: zeigt eine perspektivische Ansicht des Griffgummis.

### Beschreibung der Ausführungsformen

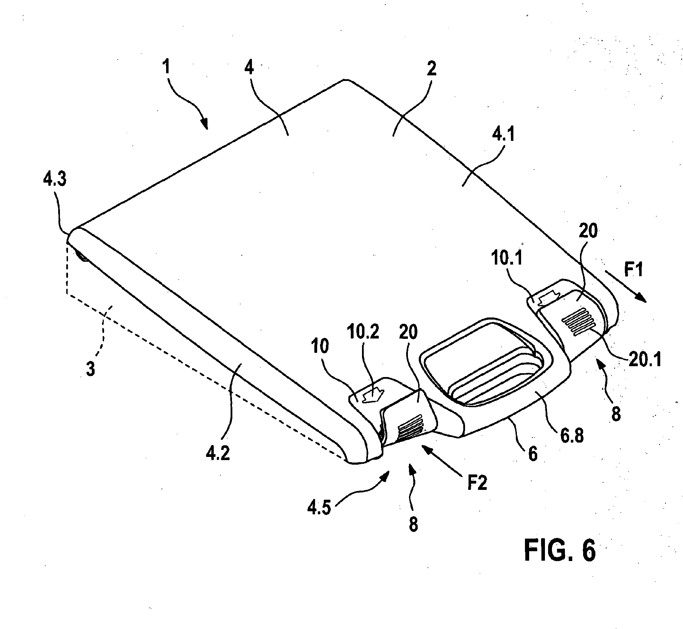

Ein tragbarer Mischverstärker 1 ist in Figur 6 angedeutet und weist einen erfindungsgemäßen Gerätedeckel 2 und ein in Figur 6 gestrichelt angedeutetes Geräteunterteil 3 auf. Das Geräteunterteil 3 ist als solches mit der Funktionalität eines Mischverstärkers bekannt und weist auf seiner Oberseite zu schützende bzw. abzudeckende Bedieneinrichtungen zur Tonmischung sowie Anschlüsse auf.

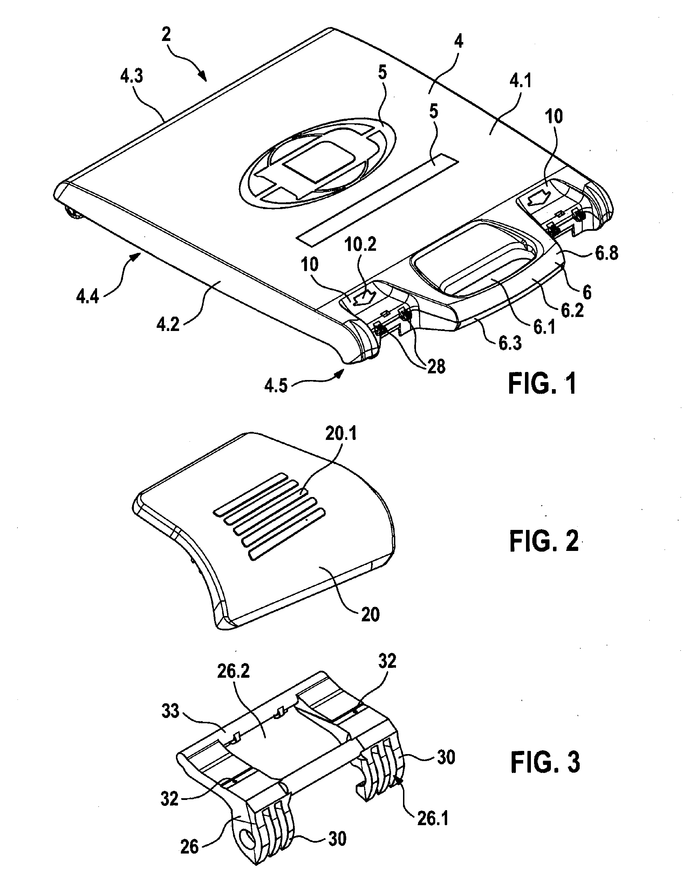

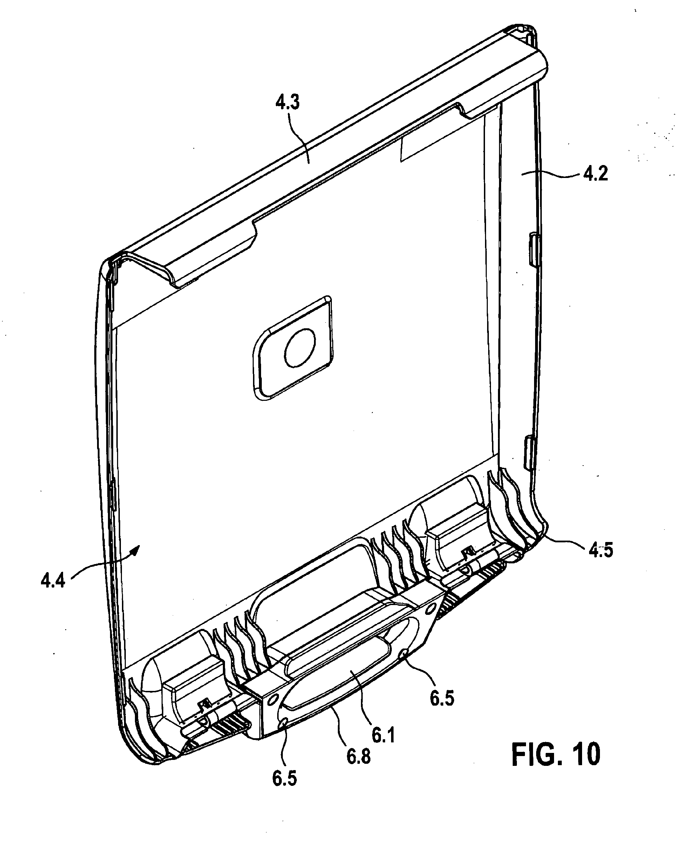

Der Gerätedeckel 2 weist eine Deckelschale 4 auf, die z. B. aus Figur 1 ersichtlich ist und einteilig als Kunststoff-Spritzgussteil aus PC/ABS (polycarbonateacrylonitrile butadiene styrene polymer) gefertigt und daher schlagfest und bruchsicher ist; sie ist z. B. in einem Temperaturbereich von -20° bis 60° C beständig. Die Deckelschale 4 weist eine plane oder leicht gewölbte Vorderseite 4.1 auf, in der ggf. beim Spritzgussvorgang ausgebildete Prägungen (Vertiefungen oder Erhöhungen) 5 ausgebildet werden können, die zur Kennzeichnung und ggf. Verzierung dienen können. Weiterhin weist die Deckelschale 4 ein oder zwei Seitenflächen 4.2, eine hintere Seitenfläche 4.3 und gegenüberliegend eine Frontseite (Griffseite) 4.5 auf; eine Rückseite 4.4 ist halb offen und dient zum Aufsetzen auf das Geräteunterteil 3, sie ist detaillierter in Figur 10 gezeigt.

Der erfindungsgemäße Gerätedeckel 2 weist weiterhin an der Frontseite 4.5 einen Griff 6 als Trageeinrichtung auf, wobei der Griff 6 einen Bügel 6.8 aufweist und ein Griffloch 6.1 vollständig umschließt. Der Griff 6 kann somit von einer Person mit einer Hand genommen und getragen werden. Neben dem Griff 6 sind zwei Verschlusseinrichtungen 8 ausgebildet, die in Verschluss-Vertiefungen 10 der Deckelschale 4 eingesetzt sind. In den Verschluss-Vertiefungen 10 können Symbole, insbesondere Pfeile, als Prägungen 10.2 ausgebildet sein, insbesondere zur Darstellung einer Betätigungsrichtung.

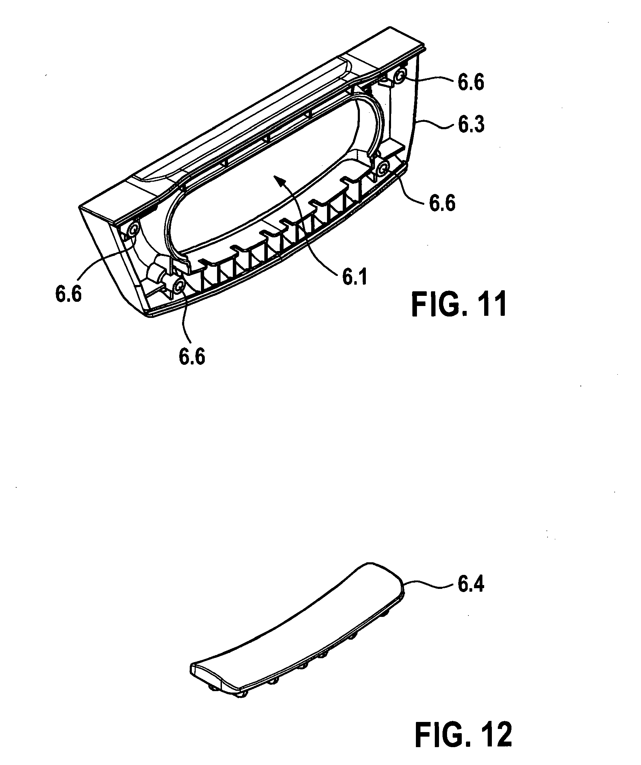

Der Griff 6 wird durch einen oberen Griffbereich 6.2, der ein Teil der Deckelschale 4 ist, weiterhin eine von unten an den Griffbereich 6.2 geschraubte, in Fig. 11 gezeigte Griffschale 6.3 und ein eingesetztes, in Fig. 12 gezeigtes Griffgummi 6.4 gebildet. Die Griffschale 6.3 sowie das Griffgummi 6.4 sind somit zusätzliche Teile, die mit dem Griffbereich 6.2 der Deckelschale 4 verbunden sind. Aus der Unteransicht (Hinteransicht) der Figur 10 sind Schraubenlöcher 6.5 am Griffbereich 6.2 erkennbar; entsprechende Schraubenlöcher bzw. Schrauben-Dome 6.6 der Griffschale 6.3 sind in Fig. 11 erkennbar, wobei die Schraubenlöcher 6.5 mit den Schrauben-Domen 6.6 fluchten, so dass von unten Schrauben, z. B. Kunststoffschrauben, zur Befestigung der Griffschale 6.3 eingeschraubt werden können. Das Griffgummi 6.4 dient dazu, die Innenseite des Griffs 6 im Bereich des Bügels 6.8 auszukleiden, um für den Benutzer ein angenehmes, geschmeidiges Griffgefühl zu erzeugen und somit eine angenehme Haptik zu erreichen. Hierzu kann das Griffgummi z. B. zwischen der Griffschale 6.3 und dem Griffbereich 6.2 oder auch nur an dem Griffbereich 6.2 aufgenommen sein.

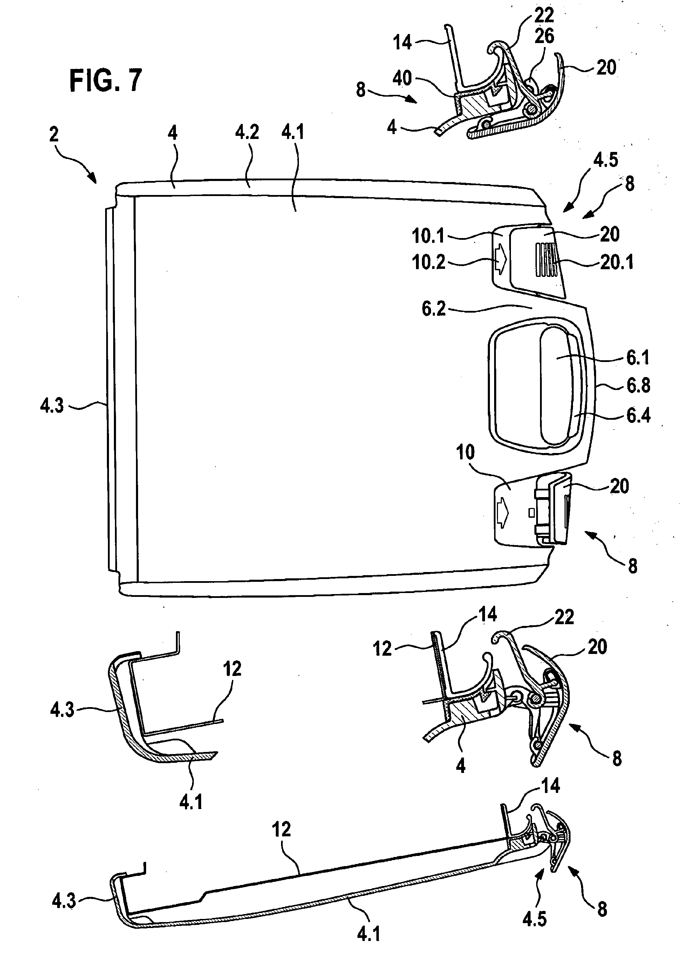

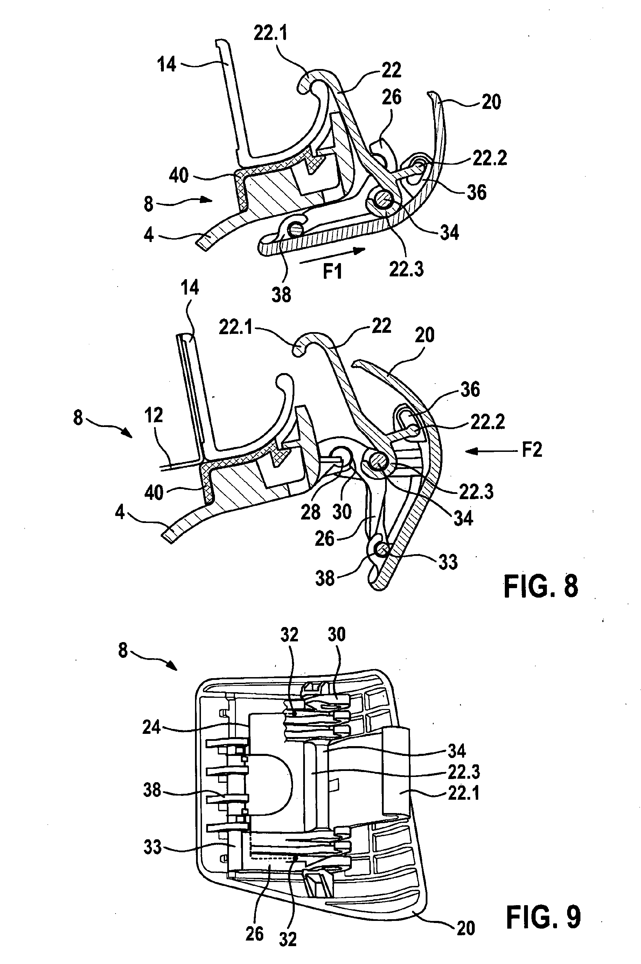

Die Verschlusseinrichtungen 8 sind in Figur 7 unten in geöffnetem Zustand und oben in geschlossenem Zustand gezeigt. Ihr Aufbau und ihre Funktionalität sind insbesondere aus den vergrößerten Schnittdarstellungen der Figur 8 und der Unteransicht der Figur 9 erkennbar.

Von dem Geräteunterteil 3 ist aus der Schnittdarstellung der Figur 7 zunächst eine Frontplatte 12 sowie ein (nicht schraffierter) Frontbacken 14 erkennbar. Zur Anbringung wird der Gerätedeckel 2 von der Hinterseite her, d.h. in Fig. 7 von links, auf das Geräteunterteil 3 bzw. dessen Frontplatte 2 aufgeschoben, so dass die hintere Seitenfläche 4.3 der Deckelschale 4 die Frontplatte 2 umgreift, und dann die Deckelschale 4 in ihrem Frontbereich, d. h. in Figur 7 rechts aufgelegt, so dass nachfolgend die Verschlusseinrichtungen 8 vom Benutzer manuell verriegelt werden können.

Jede Verschlusseinrichtung 8 weist ein in Figur 2 gezeigtes Verschlussteil 20 auf, das vorzugsweise aus demselben Kunststoff wie die Deckelschale 4 gefertigt ist, insbesondere auch mit gleicher Oberflächenbeschaffenheit und Farbgebung, um in dem geschlossenen Zustand mit der Vorderseite 4.1 zu fluchten. Die Wölbung des Verschlussteils 20 entspricht hierbei der Wölbung der Deckelschale 4 in diesem Bereich, d.h. zur Frontseite (Griffseite) 4.5 hin, so dass gemäß Figur 6 das Verschlussteil 20 sich der Formgebung der Vorderseite 4.1 anpasst. Wie aus Figur 6 und Figur 7 erkennbar ist, ist ein hinterer Teil 10.1 der Verschlussvertiefung 10 von dem Verschlussteil 20 in dessen geschlossener (verriegelter) Stellung nicht abgedeckt, wobei in diesem hinteren Teil 10.1 die Prägung 10.2 für die Kennzeichnung zur Andeutung der Betätigungsrichtung vorgersehen ist.

Das Verschlussteil 20 kann auf seiner Oberseite eine Grifffläche 20.1 zur zur Erhöhung der Rauhigkeit aufweisen, z. B. durch Stege oderr Vorsprünge 20.1 oder entsprechende Ausprägungen, damit der Benutzer diese raueren Griffflächen 20.1 mit seinem Finger, z. B. Daumen, besser erfassen und betätigen kann.

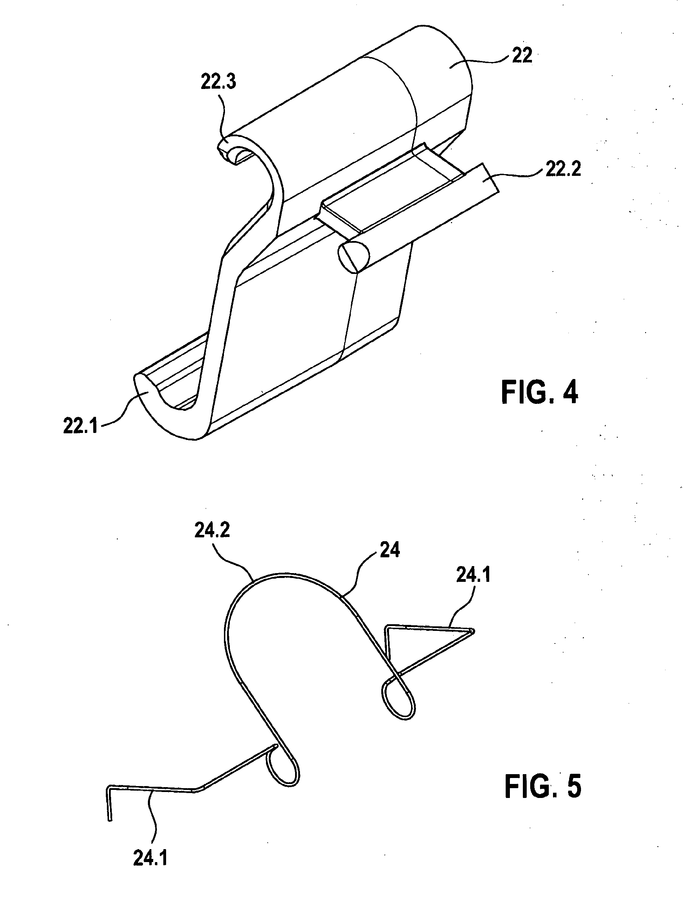

Die Verschlusseinrichtung 8 weist neben dem Verschlussteil 20 weiterhin einen in Fig. 4 detaillierter gezeigten Haken 22 aus Kunststoff (oder auch Metall), eine in Fig. 5 gezeigte Feder 24 aus Metall sowie ein in Fig. 3 gezeigtes Rahmenteil 26 auf, die gemäß den Schnittdarstellungen zusammengesetzt sind:
Das Rahmenteil 26 dient zum einen als Koppel zwischen dem Verschlussteil 20 und der Deckelschale 4 und weiterhin zur Aufnahme des Hakens 22, wie nachfolgend detaillierter beschrieben wird:
   In der Verschlussvertiefung 10 der Deckelschale 4 sind jeweils zwei Achsen 28 ausgebildet, die als Teil des Kunststoff-Spritzgussmaterials des Deckels 4 etwas vorstehen. Die Achsen 28 dienen zur schwenkbaren Anbindung von Achsaufnahmen 30 des Rahmenteils 26, das somit schwenkbar gelagert ist. Die Achsen 28 weisen seitlich verlaufende Achsbolzen- Bereiche und z. B. ergänzende, lamellenartige Stege auf, die in entsprechende, aus Figur 3 ersichtliche Schlitze 26.1 des Rahmenteils 26 eingreifen. Die Achsen 28 schnappen bei der Montage somit in die Achsaufnahmen 30 des Rahmenteils 26 ein, wozu gemäß Figur 3 z. B. die rechte Achsaufnahme 30 halb offen und die linke Achsaufnahme 30 geschlossen ist, so dass die in Figur 1 linke Achse 28 der linken Verschlusseinrichtung 28 in die geschlossene Achsaufnahme 30 eingesetzt wird, und in einer Schwenkbewegung nachfolgend die rechte Achse 28 in die halb offene Achsaufnahme 30 einschnappen kann. Hierdurch wird ein einfacher Montageschritt gewährleistet.

Wie aus Figur 3 zu erkennen ist, weist das Rahmenteil 26 auf seiner Oberseite zwei Löcher 32 auf. Die Feder 24 weist Federschenkel 24.1 auf, die mit ihren Enden in die Löcher 32 gesteckt werden, und einen mittleren Anlagebereich (Bügelbereich) 24.2, der zur Anlage an der Innenseite des Verschlussteils 20 dient, wie insbesondere aus Figur 9 erkennbar ist. Die Feder 24 ist vorteilhafterweise symmetrisch ausgebildet. Die Feder 24 liegt somit mit ihren Schenkeln 24.1 auf der in Figur 3 oberen Seite des Rahmenteils 26 auf und erstreckt sich mit ihrem mittleren Auflagebereich 24.2 durch ein mittiges Loch 26.2 des Rahmenteils 26, um auf dem Verschlussteil 20 aufzuliegen und eine Federwirkung zwischen dem Verschlussteil 20 und dem Rahmenteil 26 auszubilden.

Der Haken 22 dient zur Verriegelung an dem Frontbalken 14, wie aus Figur 8 erkennbar ist. Hierzu ist der Haken 22 schwenkbar in einer Haken-Achse 34 eingehängt, die als Teil des Rahmenteils 26 ausgebildet ist. Somit schwenkt der Haken 22 um das Rahmenteil 26, wobei der Haken 22 weiterhin in einem Langloch 36 geführt ist, das in dem Verschlussteil 20 bzw. als Teil des Verschlussteils 20 ausgebildet ist. Das Langloch 36 dient zum einen der Führung des Hakens 22, damit dieser zusätzlich zu der Hakenachse 34 in einem weiteren Bereich und somit sicherer geführt ist, und zum anderen der Begrenzung der Schwenkbewegung des Hakens 22, um Beschädigungen zu vermeiden. Die Feder 24 sorgt dafür, dass der Haken 22 vom Frontbalken 14 weggedrückt wird und die Verschlusseinrichtung 8 in der geöffneten Stellung gehalten wird, was für den Benutzer visuell erkennbar ist

Das Rahmenteil 26 ist vorteilhafterweise in z. B. einer Achsanbindung (z. B. Lasche) 38 des Verschlussteils 20 eingehängt, wie z. B. aus Figur 8, obere Darstellung erkennbar ist, wobei in Figur 8 das Rahmenteil 26 somit an zwei Stellen durch enge Schraffur in seiner Schnittfläche erkennbar ist, nämlich seiner Hakenachse 34 zur Aufnahme des Hakens 22 und seinem Achsbereich 33, mit dem er in der Achsaufnahme 38 des Verschlussteils 20 eingehängt ist

Gemäß Figur 8 kann zwischen den Frontbalken 14 des Geräteunterteils 3 und die Deckelschale 4 ein Gummi-Einlegeteil 40 (enge Schraffur) eingelegt sein, wobei dieses z. B. formschlüssig einschnappt oder auch an die Deckelschale 4 geklebt sein kann, um als Dämpfung bzw. Schock-Absorber beim Auflegen des Gerätedeckels 2 auf das Geräteunterteil 3 zu dienen.

Die Verstell-Kinematik ist somit insbesondere aus den beiden Darstellungen der Figur 8 erkennbar: von der oberen, verriegelten Stellung der Verschlusseinrichtung 8 ausgehend betätigt der Benutzer das Verschlussteil 20, indem er in den offen liegenden hinteren Teil 10.1 der Verschluss-Vertiefung 10 eingreift und das Verschlussteil 20 von hinten in Kraftrichtung Fig. 1 nach vorne hin drückt, d. h. in Figur 8 nach rechts. Das Rahmenteil 26 schwingt mit seiner Achsaufnahme 30 um die Achse 28 der Deckelschale 4 und ist mit seinem Achsbereich 33 in der Achsaufnahme 38 des Verschlussteils 20 eingehängt, so dass das Verschlussteil 20 mit dem als Koppelglied wirkenden Rahmenteil 26 um die Deckelschale 4 schwenkt. Hierbei schwenkt das Verschlussteil 20 gemäß Figur 8, untere Darstellung im Bereich ihrer Achsaufnahme 38, d. h. ihres hinteren Endes nach oben weg, so dass die geöffnete Position der Figur 8, unten, für den Benutzer eindeutig erkennbar ist. Die Federvorspannung der Feder 24 drückt in die geöffnete Stellung der Figur 8, unten, so dass auch bei teilweiser Entriegelung diese für den Benutzer gut erkennbare offene Stellung der Figur 8 unten erreicht wird. Bei dieser Schwenkbewegung wird das Rahmenteil 26 und somit auch die Hakenachse 34 mitverstellt, so dass der Haken 22 in Figur 8 nach rechts und außer Eingriff mit den Frontbaken 14 gelangt.

Zum Verriegeln wird von Figur 8, unten ausgehend das Verschlussteil 20, wiederum z. B. an seinen Griffflächen 20.1 vom Benutzer mitgenommen und in Richtung des Kraftpfeils F2 gedrückt, d.h. in Figur 7 und 8 nach links. Durch diese Kraft F2 wird der Haken 22 wiederum an den Frontbalken 14 gedrückt und ergreift diesen, so dass die Verschlusseinrichtung 8 in umgekehrter kinematischer Bewegung verstellt wird, bis die verriegelte Stellung der Figur 8 oben erreicht ist. Bei Erreichen der verriegelten Stellung der Figur 8 oben wird vorteilhafterweise ebenfalls ein Klick-Geräusch erzeugt, z. B. durch das anschlagende Verschlussteil 20.

Die Betätigungen der beiden Verschlusseinrichtungen 8 können vom Benutzer separat oder auch gleichzeitig vorgenommen werden. Eine offene Stellung ist aufgrund der nicht mehr fluchtenden, vorstehenden Position des Verschlussteils 20 gemäß der Darstellung, z. B. Figur 6, links, gut erkennbar; auch die verriegelte Stellung ist aufgrund der fluchtenden Passform des Verschlussteils 20 in der Vorderseite 4.1 gut erkennbar.

Die Montage der Verschlusseinrichtungen 8 bei der Fertigung ist relativ einfach. Die Feder 24 wird mit ihren Schenkeln 24.1 in die Löcher 32 des Rahmenteils 26 gesteckt. Das Rahmenteil 26 wird (vor oder nach Anbringung der Feder 24) in die Achsaufnahme 38 des Verschlussteils 20 eingehängt (geklipst). Der Haken 22 wird wiederum in die Hakenaufnahme 34 des Rahmenteils 26 eingehängt, wobei diese Montageschritte grundsätzlich auch in anderer Reihenfolge erfolgen können, relevant ist die Ausbildung eines kombinierten Verschlussmechanismus bzw. der Verschlusseinrichtung 8, die nachfolgend an der Deckelschale 4 eingehängt wird, indem das Rahmenteil 26 mit seiner Achsaufnahme 30 in die Achse 28 der Deckelschale 4 eingehängt wird. Dieses Einhängen der Achsen erfolgt jeweils mit einem Einrastvorgang und ist somit verliersicher.

Zum Befestigen des Gerätedeckels 2 auf dem Geräteunterteil 3 wird der Gerätedeckel 2 zunächst mit seiner hinteren Seitenfläche 4.3 an an der Frontplatte 12 des Geräteunterteils 3 eingehängt, und dann mit seiner Griffseite auf den Frontbacken 14 des Geräteunterteils 3 gelegt, wobei durch das Gummi-Einlegeteil 40 eine Dämpfung bzw. Schock-Absorbung erreicht wird. Nachfolgend können die Verschlusseinrichtungen 8 separat verriegelt werden.

## Patentansprüche

1. Gerätedeckel (2) für einen tragbaren elektronischen Mischverstärker (1), wobei der Gerätedeckel (2) mindestens aufweist:
eine Deckelschale (4) mit einer Vorderseite (4.1) und mit einer Rückseite (4.4) zum Aufsetzen auf ein Geräteunterteil (3) des Mischverstärkers (1), Verschlusseinrichtungen (8) zum Verriegeln des Gerätedeckels (2) an dem Geräteunterteil (3), wobei die Verschlusseinrichtungen (8) zwischen einer offenen und einer verriegelten Stellung verstellbar sind,
**dadurch gekennzeichnet, dass**
der Gerätedeckel (2) eine Trageeinrichtung (6) zum Ergreifen durch einen Benutzer aufweist, und
in der Deckelschale (4) Verschluss-Vertiefungen (10) ausgebildet sind, in denen die Verschlusseinrichtungen (8) aufgenommen sind.

2. Gerätedeckel nach Anspruch 1, **dadurch gekennzeichnet, dass** die Verschlusseinrichtungen (8) derartig in den Verschluss-Vertiefungen (10) aufgenommen sind, dass eine verriegelte Verschlusseinrichtung (8) im Wesentlichen mit der Vorderseite (4.1) der Deckelschale (4) fluchtet oder nicht übersteht, und eine nicht verriegelte Verschlusseinrichtung (8) über die Vorderseite (4.1) der Deckelschale (4) vorsteht.

3. Gerätedeckel nach Anspruch 2, **dadurch gekennzeichnet, dass** die Verschlusseinrichtungen (8) jeweils ein Verschlussteil (20) aufweisen, das eine Grifffläche (20.1) zur Betätigung durch den Benutzer aufweist und auf seiner Oberseite mit einer Formgebung entsprechend der Vorderseite (4.1) der Deckelschale (4) ausgebildet ist,
wobei das Verschlussteil (20 in der geschlossenen Stellung der Verschlusseinrichtung (8) mit der Vorderseite (4.1) der Deckelschale (4) fluchtet und in entriegelter Stellung der Verschlusseinrichtung (8) über die Vorderseite (4.1) vorsteht.

4. Gerätedeckel nach Anspruch 3, **dadurch gekennzeichnet, dass** das Verschlussteil (20) in der verriegelten Stellung einen hinteren Teil (10.1) der Verschluss-Vertiefung (10) frei lässt, wobei in dem hinteren Teil (10.1) eine Einprägung oder Vorsprung, z. B. als Pfeil (10.2), ausgebildet ist zur Kennzeichnung der Verstellrichtung des Verschlussteils (20).

5. Gerätedeckel (2) nach Anspruch 3 oder 4, **dadurch gekennzeichnet, dass** jede Verschlusseinrichtung (8) weiterhin ein Rahmenteil (26) aufweist, das als Koppelglied zwischen der Deckelschale (4) und dem Verschlussteil (20) angeordnet und mit diesen jeweils gelenkig verbunden ist.

6. Gerätedeckel nach einem der Ansprüche 3 bis 5, **dadurch gekennzeichnet, dass** jede Verschlusseinrichtung (8) eine Federeinrichtung (24) aufweist zur Ausübung einer Vorspannung auf das Verschlussteil (20) in dessen entriegelte, offene Stellung und/oder dessen verriegelte Stellung.

7. Gerätedeckel nach Anspruch 6, **dadurch gekennzeichnet, dass** die Federeinrichtung (24) zwischen dem Rahmenteil (26) und dem Verschlussteil (20) vorgesehen ist, z. B. durch feste Anbindung an dem Rahmenteil (26) und Anlage an der Unterseite des Verschlussteils (20).

8. Gerätedeckel nach einem der Ansprüche 3 bis 7, **dadurch gekennzeichnet, dass** jede Verschlusseinrichtung (8) eine Eingriffseinrichtung (22), z. B. einen Haken (22) aufweist, zum formschlüssigen Eingriff in das Geräteunterteil (3) in der verriegelten Stellung, wobei die Eingriffseinrichtung bei Verstellung in die verriegelte Stellung unter Ausbildung eines akustischen Geräuschs einschnappt.

9. Gerätedeckel nach Anspruch 8, **dadurch gekennzeichnet, dass** die Eingriffseinrichtung als schwenkbarer Haken (22) ausgebildet und an einem Koppelglied (26), vorzugsweise dem Rahmenteil (26), angelenkt ist.

10. Gerätedeckel nach Anspruch 9, **dadurch gekennzeichnet, dass** der Haken (22) ergänzend an dem Verschlussteil (20) geführt ist, z. B. in einem Langloch (36) des Verschlussteils, (20) zur Führung und Festlegung eines maximalen Schwenkbereichs.

11. Gerätedeckel nach einem der vorherigen Ansprüche, **dadurch gekennzeichnet, dass** die Deckelschale (4) durch ein Spritzgussverfahren aus einem Kunststoffmaterial gefertigt ist, insbesondere einem PC/ABS.

12. Gerätedeckel nach einem der vorherigen Ansprüche, **dadurch gekennzeichnet, dass** die Trageeinrichtung als Griff (6) mit einem Griffloch (6.1) und einem umfassbaren Bügel (6.8) ausgebildet ist,
wobei die Deckelschale (4) einen Griffbereich (6.2) aufweist, der sich bis in den Bügel (6.8) erstreckt und das Griffloch (6.1) umgibt.

13. Gerätedeckel (2) nach Anspruch 12, **dadurch gekennzeichnet, dass** der Griff (6) weiterhin eine Griffschale (6.3) aufweist, die als separates Bauteil an dem Griffbereich (6.2) der Deckelschale (4) befestigt, z. B. von unten angeschraubt ist, wobei ein weiches Griffmaterial-Teil, z. B. ein Griffgummi (6.4), an der Griffschale (6.3) und/oder dem Griffbereich (6.2) der Deckelschale (4) aufgenommen ist, insbesondere am Innenbereich des Bügels (6.8).

14. Gerätedeckel nach einem der vorherigen Ansprüche, **dadurch gekennzeichnet, dass** die Trageeinrichtung (6) und zwei Verschlusseinrichtungen (8) an einer Frontseite (4.5) vorgesehen sind, wobei die Trageeinrichtung (6) zwischen den Verschlusseinrichtungen (8) angeordnet ist.

15. Tragbarer Mischverstärker (1), der einen Gerätedeckel (2) nach einem der vorherigen Ansprüche und ein Geräteunterteil (3) aufweist,
wobei der Gerätedeckel (2) das Geräteunterteil (3) formschlüssig umgreift und durch eine Verriegelungseinrichtungen (8) mit diesem verriegelt ist, wobei der Gerätedeckel (2) eine Trageeinrichtung (6) zum Ergreifen durch einen Benutzer aufweist.

16. Tragbarer Mischverstärker (1) nach Anspruch 15, **dadurch gekennzeichnet, dass** das Geräteunterteil (3) Toneingänge zur Aufnahme verschiedener Signalquellen, und einen Verstärkerausgang zum Betreiben von Lautsprechern, sowie Betätigungseinrichtungen zur Einstellung von Mischwirkungen aufweist.

## Claims

1. Cover (2) for a portable electronic mixer amplifier (1), the cover (2) having at least:
a cover shell (4) having a front side (4.1) and having a rear side (4.4) to be placed on a lower part (3) of the mixer amplifier (1), closure devices (8) for locking the cover (2) to the lower part (3), the closure devices (8) being displaceable between an open and a locked position,
**characterized in that**
the cover (2) has a carrying device (6) to be grasped by a user, and
closure depressions (10), in which the closure devices (8) are accommodated, are formed in the cover shell (4).

2. Cover according to Claim 1, **characterized in that** the closure devices (8) are accommodated in the closure depressions (10) in such a way that a locked closure device (8) is substantially aligned with the front side (4.1) of the cover shell (4) or does not protrude, and an unlocked closure device (8) projects beyond the front side (4.1) of the cover shell (4).

3. Cover according to Claim 2, **characterized in that** the closure devices (8) each have a closure part (20) which has a gripping surface (20.1) for actuation by the user and, on its upper side, is formed with a shape corresponding to the front side (4.1) of the cover shell (4),
wherein, in the closed position of the closure device (8), the closure part (20) is aligned with the front side (4.1) of the cover shell (4) and, in the unlocked position of the closure device (8), protrudes beyond the front side (4.1).

4. Cover according to Claim 3, **characterized in that**, in the locked position, the closure part (20) exposes a rear part (10.1) of the closure depression (10), an indentation or protrusion being formed in the rear part (10.1), e.g. as an arrow (10.2), in order to identify the displacement direction of the closure part (20).

5. Cover (2) according to Claim 3 or 4, **characterized in that** each closure device (8) also has a frame part (26), which is arranged as a coupling element between the cover shell (4) and the closure part (20) and is respectively connected to the latter in an articulated manner.

6. Cover according to one of Claims 3 to 5, **characterized in that** each closure device (8) has a spring device (24) to exert a preload on the closure part (20) in the unlocked, open position and/or locked position of the latter.

7. Cover according to Claim 6, **characterized in that** the spring device (24) is provided between the frame part (26) and the closure part (20), e.g. by means of a fixed attachment to the frame part (26) and contact with the underside of the closure part (20).

8. Cover according to one of Claims 3 to 7, **characterized in that** each closure device (8) has an engagement device (22), e.g. a hook (22), to engage in a form-fitting manner in the lower part (3) in the locked position, wherein the engagement device snaps in as it is displaced into the locked position, making an acoustic noise.

9. Cover according to Claim 8, **characterized in that** the engagement device is formed as a pivotable hook (22) and is hinged on a coupling element (26), preferably the frame part (26).

10. Cover according to Claim 9, **characterized in that** the hook (22) is also guided on the closure part (20), e.g. in a slot (36) in the closure part (20), in order to guide and define a maximum pivoting range.

11. Cover according to one of the preceding claims, **characterized in that** the cover shell (4) is made by an injection moulding method from a plastic material, in particular a PC/ABS.

12. Cover according to one of the preceding claims, **characterized in that** the carrying device is formed as a handle (6) having a handle hole (6.1) and a bow (6.8) that can be clasped,
wherein the cover shell (4) has a grip region (6.2), which extends as far as the bow (6.8) and surrounds the handle hole (6.1).

13. Cover (2) according to Claim 12, **characterized in that** the handle (6) also has a handle shell (6.3), which, as a separate component, is fixed to the grip region (6.2) of the cover shell (4), e.g. is screwed on from below, wherein a soft grip material part, e.g. a grip rubber (6.4), is accommodated on the handle shell (6.3) and/or the grip region (6.2) of the cover shell (4), in particular in the inner region of the bow (6.8).

14. Cover according to one of the preceding claims, **characterized in that** the carrying device (6) and two closure devices (8) are provided on the front side (4.5), wherein the carrying device (6) is arranged between the closure devices (8).

15. Portable mixer amplifier (1), which has a cover (2) according to one of the preceding claims and a lower part (3),
wherein the cover (2) engages around the lower part (3) with a form fit and is locked to the latter by locking devices (8),
wherein the cover (2) has a carrying device (6) to be grasped by a user.

16. Portable mixer amplifier (1) according to Claim 15, **characterized in that** the lower part (3) has sound inputs for picking up various signal sources and an amplifier output for operating loudspeakers, and also actuating devices for setting mixing actions.

## Revendications

1. Couvercle (2) pour un amplificateur-mélangeur électronique portable (1), dans lequel le couvercle (2) présente au moins:
une coque de couvercle (4) avec un côté avant (4.1) et avec un côté arrière (4.4) à poser sur un corps d'appareil (3) de l'amplificateur-mélangeur (1),
des dispositifs de verrouillage (8) pour le verrouillage du couvercle (2) sur le corps d'appareil (3), dans lequel les dispositifs de verrouillage (8) sont déplaçables entre une position ouverte et une position verrouillée,
**caractérisé en ce que**
le couvercle (2) présente un dispositif de portage (6) à saisir par un utilisateur, et des creux de verrouillage (10) sont formés dans la coque de couvercle (4), dans lesquels les dispositifs de verrouillage (8) sont logés.

2. Couvercle selon la revendication 1, **caractérisé en ce que** les dispositifs de verrouillage (8) sont logés dans les creux de verrouillage (10), de telle manière qu'un dispositif de verrouillage (8) verrouillé se trouve essentiellement au niveau du côté avant (4.1) de la coque de couvercle (4) et ne dépasse pas, et qu'un dispositif de verrouillage (8) non verrouillé soit saillant au-dessus du côté avant (4.1) de la coque de couvercle (4).

3. Couvercle selon la revendication 2, **caractérisé en ce que** les dispositifs de verrouillage (8) présentent respectivement une pièce de verrouillage (20), qui présente une face de prise (20.1) pour l'actionnement par l'utilisateur et est dotée sur son côté supérieur d'une forme correspondant au côté avant (4.1) de la coque de couvercle (4),
dans lequel la pièce de verrouillage (20) dans la position fermée du dispositif de verrouillage (8) se trouve au niveau du côté avant (4.1) de la coque de couvercle (4) et est saillante au-dessus du côté avant (4.1) dans la position déverrouillée du dispositif de verrouillage (8).

4. Couvercle selon la revendication 3, **caractérisé en ce que** la pièce de verrouillage (20) dans la position verrouillée laisse libre une partie arrière (10.1) du creux de verrouillage (10), dans lequel une empreinte ou une saillie, par exemple en forme de flèche (10.2), est formée dans la partie arrière (10.1) pour indiquer la direction de déplacement de la pièce de verrouillage (20) .

5. Couvercle (2) selon la revendication 3 ou 4, **caractérisé en ce que** chaque dispositif de verrouillage (8) présente en outre une pièce de cadre (26), qui est disposée en tant qu'organe de couplage entre la coque de couvercle (4) et la pièce de verrouillage (20) et qui est reliée respectivement à celles-ci de façon articulée.

6. Couvercle selon l'une quelconque des revendications 3 à 5, **caractérisé en ce que** chaque dispositif de verrouillage (8) présente un système de ressort (24) pour exercer une précontrainte sur la pièce de verrouillage (20) dans sa position ouverte déverrouillée et/ou dans sa position verrouillée.

7. Couvercle selon la revendication 6, **caractérisé en ce que** le système de ressort (24) est prévu entre la pièce de cadre (26) et la pièce de verrouillage (20), par exemple par liaison fixe à la pièce de cadre (26) et appui sur le côté inférieur de la pièce de verrouillage (20).

8. Couvercle selon l'une quelconque des revendications 3 à 7, **caractérisé en ce que** chaque dispositif de verrouillage (8) présente un dispositif d'accrochage (22), par exemple un crochet (22), pour l'engagement par emboîtement dans le corps d'appareil (3) dans la position verrouillée, dans lequel le dispositif d'accrochage s'encliquète en émettant un bruit acoustique lors du déplacement dans la position verrouillée.

9. Couvercle selon la revendication 8, **caractérisé en ce que** le dispositif d'accrochage est réalisé en forme de crochet pivotant (22) et est articulé à un organe de couplage (26), de préférence à la pièce de cadre (26).

10. Couvercle selon la revendication 9, **caractérisé en ce que** le crochet (22) est guidé en complément sur la pièce de verrouillage (20), par exemple dans un trou oblong (36) de la pièce de verrouillage (20) pour le guidage et la fixation d'une zone pivotante maximale.

11. Couvercle selon l'une quelconque des revendications précédentes, **caractérisé en ce que** la coque de couvercle (4) est fabriquée par un procédé de moulage par injection en une matière plastique, en particulier en un PC/ABS.

12. Couvercle selon l'une quelconque des revendications précédentes, **caractérisé en ce que** le dispositif de portage est réalisé sous forme de poignée (6) avec un trou de saisie (6.1) et une anse à empoigner (6.8), dans lequel la coque de couvercle (4) présente une zone de saisie (6.2), qui s'étend jusque dans l'anse (6.8) et entoure le trou de saisie (6.1).

13. Couvercle (2) selon la revendication 12, **caractérisé en ce que** la poignée (6) présente en outre une coque de saisie (6.3), qui est fixée en tant que composant séparé à la zone de saisie (6.2) de la coque de couvercle (4), par exemple vissée par-dessous, dans lequel une pièce en matière de prise souple, par exemple un caoutchouc de saisie (6.4), est posé sur la coque de saisie (6.3) et/ou la zone de saisie (6.2) de la coque de couvercle (4), en particulier dans la région intérieure de l'anse (6.8).

14. Couvercle selon l'une quelconque des revendications précédentes, **caractérisé en ce que** le dispositif de portage (6) et deux dispositifs de verrouillage (8) sont prévus sur un côté frontal (4.5), dans lequel le dispositif de portage (6) est disposé entre les dispositifs de verrouillage (8).

15. Amplificateur-mélangeur portable (1), qui présente un couvercle (2) selon l'une quelconque des revendications précédentes, dans lequel le couvercle (2) s'emboîte en périphérie sur le corps d'appareil (3) et est verrouillé sur celui-ci par des dispositifs de verrouillage (8), dans lequel le couvercle (2) présente un dispositif de portage (6) à saisir par un utilisateur.

16. Amplificateur-mélangeur portable (1) selon la revendication 15, **caractérisé en ce que** le corps d'appareil (1) présente des entrées audio pour l'enregistrement de diverses sources de signaux, et une sortie d'amplificateur pour activer des haut-parleurs, ainsi que des dispositifs d'actionnement pour le réglage des effets de mixage.
